(19) Europäisches Patentamt
European Patent Office
Office européen des brevets

(11) Veröffentlichungsnummer: **0 210 436 B1**

(12) **EUROPÄISCHE PATENTSCHRIFT**

(45) Veröffentlichungstag der Patentschrift: **04.09.91**

(51) Int. Cl.5: **C23C 18/18**

(21) Anmeldenummer: **86108643.7**

(22) Anmeldetag: **25.06.86**

# (54) Verfahren zur Metallisierung von Keramik.

(30) Priorität: **04.07.85 DE 3523957**

(43) Veröffentlichungstag der Anmeldung:
**04.02.87 Patentblatt 87/06**

(45) Bekanntmachung des Hinweises auf die Patenterteilung:
**04.09.91 Patentblatt 91/36**

(84) Benannte Vertragsstaaten:
**AT BE CH DE FR GB IT LI LU NL SE**

(56) Entgegenhaltungen:
**EP-A- 0 035 626**
**EP-A- 0 128 476**

(73) Patentinhaber: **Licentia Patent-Verwaltungs-GmbH**
**Theodor-Stern-Kai 1**
**W-6000 Frankfurt/Main 70(DE)**

(72) Erfinder: **Bogenschütz, August-Friedrich, Prof.Dr.rer.nat**
**Beethovenstrasse 10**
**W-7931 Oberdischingen(DE)**
Erfinder: **Jostan, Josef L., Dr.rer.nat.**
**Haslacherweg 21**
**W-7900 Ulm(DE)**
Erfinder: **Ostwald, Robert, Dr.-Ing.**
**Hasensteige 8**
**W-7900 Ulm(DE)**

(74) Vertreter: **Amersbach, Werner, Dipl.-Ing. et al**
**Licentia Patent-Verwaltungs-GmbH Theodor-Stern-Kai 1**
**W-6000 Frankfurt 70(DE)**

**EP 0 210 436 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Metallisierung von Keramik nach Patentanspruch 1.

Es ist bekannt, daß beispielsweise die in der Elektrotechnik und Elektronik häufig eingesetzte, hochreine Aluminiumoxid-Keramik zur Verbesserung der Benetzbarkeit und der Haftfestigkeit vorteilhaft in einer alkalischen Lösung oder Schmelze vorbehandelt wird. Dabei wird die Keramik oberflächlich aufgeschlossen, chemisch inerte Oberflächenbereiche werden abgetragen und eine chemisch aktive Oberfläche wird erzeugt. Außerdem erfolgt dabei eine mehr oder weniger starke Aufrauhung der Oberfläche, die mechanische Verankerungsmöglichkeiten zur Steigerung der Haftfestigkeit der Metallauflage bietet. Ist eine Aufrauhung aus elektrischen Gründen unerwünscht, so wird ein Haftvermittler eingesetzt, z.B. $Cu_2O$ nach dem deutschen Patent DE-PS 25 33 524 oder Kieselsäure nach dem deutschen Patent DE-PS 20 04 133, der mit der Keramikoberfläche reagiert und gleichzeitig zur Kupferschicht Bindungen ausbildet. Es ist außerdem bekannt, die Keramikoberfläche durch Tauchen in Sensibilisierungs- und/oder Aktivierungslösungen mit beispielsweise Sn/Pd-Katalysatorkeimen zu belegen und anschließend mit einem handelsüblichen chemischen Kupferbad zu verkupfern. Die genannten Schritte stellen in der Regel Einzelschritte dar, die sukzessive durchgeführt werden. Ein derartiges Verfahren ist in nachteiliger Weise unwirtschaftlich, insbesondere bei einer industriellen Massenfertigung.

Aus der EP-A-0 035 626 ist ein Metallisierungsverfahren bekannt, bei welchem die zu metallisierende Keramikoberfläche zunächst mit einer Alkalimetall-Silikat-Lösung beschichtet wird. Diese Lösung enthält ein Metallsalz, das, nach einer Reduktion, katalytisch wirkt auf das aus einem stromlos chemisch arbeitenden Metallisierungsbad abzuscheidende Metall. Nach dem Auftragen der Lösung wird der entstandene Lösungsfilm getrocknet, so daß eine Schicht entsteht. Diese Schicht wird anschließend bei erhöhter Temperatur, z.B. 200° C, eingebrannt. Anschließend kann die eingebrannte Schicht mit einer auf das Metallsalz reduzierend wirkenden Lösung behandelt werden. Danach erfolgt die stromlos chemische Metallisierung, z.B. mit Nickel oder Kobalt.

Aus der EP-A-0 128 476 ist weiterhin ein Metallisierungsverfahren bekannt, bei welchem die zu metallisierende Keramikoberfläche zunächst in einer Alkalihydroxid-Schmelze, welche den Schmelzpunkt erniedrigende Zusätze enthalten kann, behandelt wird. Anschließend wird die angeätzte Oberfläche mit einer sauren Lösung, die Halogene enthält, behandelt. Diese Lösung wird an der angeätzten Oberfläche adsorbiert. Dann erfolgt eine Sensibilisierung, z.B. in einer sauren Zinnchlorid-Lösung, eine Aktivierung, z.B. in einer sauren Palladiumchlorid-Lösung, und die stromlos chemische Metallisierung, z.B. mit Kupfer.

Der Erfindung liegt daher die Aufgabe zugrunde, ein derartiges Verfahren dahingehend zu verbessern, daß einzelne Verfahrensschritte zusammengefaßt werden, daß eine hohe Haftfestigkeit der aufgebrachten Metallschicht erreicht wird und daß eine kostengünstige sowie zuverlässige Herstellung ermöglicht wird, insbesondere bei einer industriellen Massenfertigung.

Diese Aufgabe wird gelöst durch die im Patentanspruch 1 angegebenen Merkmale. Zweckmäßige Ausgestaltungen und/oder Weiterbildungen sind den Unteransprüchen entnehmbar.

Die Erfindung wird im folgenden anhand von Ausführungsbeispielen näher erläutert.

Bei einer beispielhaft gewählten Verkupferung einer Keramikoberfläche ist lediglich ein einziger Vorbehandlungsschritt erforderlich vor der eigentlichen Verkupferung. Einer dafür erforderlichen alkalischen oder sauren Vorbehandlungschmelze wird ein Haftvermittler (oder dessen Vorstufe) und/oder ein Sensibilisator (oder dessen Vorstufe) und/oder ein Aktivator im Sinne eines Katalysators (oder dessen Vorstufe) ugesetzt. Als Haftvermittler kommen insbesondere in Betracht Verbindungen der Elemente der III. bis VI. Hauptgruppe und/oder der I. bis VIII. Nebengruppe des Periodensystems, beispielsweise Silicate, Molybdate, Wolframate, Vanadate, Titanate, Stannate, Cuprate, Manganate und Ferrate in unterschiedlichen Oxidationsstufen. Die diesen Verbindungen zugrundeliegenden Oxide vermögen mit den Bestandteilen der Keramik insbesondere in der Hitze Alumosilicate, Spinelle, z.B. des Typs

$$M^{II}M_2^{III}O_4 \quad \text{oder} \quad M_2^{I}M_2^{III}O_4$$

oder andere Mischoxide zu bilden, auf denen der Haftmechanismus basiert. Dabei bedeuten $M^I$ bzw. $M^{II}$ bzw. $M^{III}$ ein- bzw. zwei- bzw. dreiwertige Elemente der genannten Gruppen.

Als Sensibilisatorzusatz wird eine alkalische Stannat(II)-Lösung verwendet oder Zinn(II)-oxid oder -hydroxid der Alkalihydroxid-Schmelze zugesetzt. Da diese Medien starke Reduktionsmittel darstellen, vermögen sie die im weiteren Verfahrensgang angebotenen $Pd^{2+}$-Ionen zu $Pd^0$-Keimen zu reduzieren, die ihrerseits bekanntlich die stromlos-chemische Kupferabscheidung katalysieren. Da Zinn(II)-haltige Medien andererseits durch Luftsauerstoff allmählich unwirksam werden, ist eine Anwendung dieser Medien unter Inertgas zweckmäßig.

Alternativ dazu können $Pd^0$- oder $Pt^0$-bildende

Aktivatoren dem alkalischen Medium als Vorstufen vorteilhaft zugesetzt werden. Geeignete Verbindungen sind beispielsweise wasserhaltige Palladium- oder Platinoxide, die in starken Alkalien, insbesondere in der Hitze, in die entsprechenden Hydroxokomplexe überführt werden, z.B. nach der Formel:

$$PtO_2 \cdot 2\,H_2O + 2\,OH^- = Pt(OH)_6^{2-}$$

Beim Tauchen des Keramikkörpers in ein solches Vorbehandlungsmedium wird die Hydroxoverbindung auf der Oberfläche adsorbiert, so daß sich beim anschließenden Eintauchen in eine reduzierend wirkende Lösung von z.B. $SnCl_2$/HCl oder Hypophosphit/NaOH oder Boranaten, Aminoboranen oder Hydrazinverbindungen, die metallischen Pt- oder Pd-Keime bilden. Auch ein direkter Aktivatorzusatz von Platin- oder Palladiummetallkolloiden ist möglich; eine Verankerung der entstehenden Kolloidteilchen erfolgt dann in der mikroaufgerauhten Oberfläche des Keramikkörpers (Substrats). Will man Kupfer als Aktivator verwenden, so ist es vorteilhaft, von der jeweiligen Vorstufe auszugehen und der Schmelze das Hydroxid $Cu(OH)_2$ zuzusetzen, das in NaOH gut löslich ist und sich bei der anschließenden Reduktionsbehandlung auf der Substratoberfläche je nach angestrebtem Einsatzfall z.B. mit Glucose als Reduktionsmittel zu $Cu_2O$ (Haftvermittler) oder mit Formaldehyd zu $Cu^O$ (Aktivatorkeim) reduzieren läßt. In letzterem Falle wirken sich Ag-Keime, die als AgOH in geringer Konzentration dem $Cu(OH)_2$ zugefügt werden und zu $Ag^O$ reduziert werden, aktivitätssteigernd aus.

Analog der Vorbehandlung von Keramik in alkalischem Medium kann das erfindungsgemäße Verfahren auch auf eine saure Vorbehandlung von bestimmten Keramiktypen, z.B. Bariumtitanat-Keramik, angewandt werden. Beispielsweise kann dem Aufschlußmedium $KHSO_4$ oder $NH_4HSO_4$ in der Schmelze Zinn(II)-sulfat als Sensibilisator zugesetzt werden, das dann bei der nachfolgenden Hydrolyse zu $Sn(OH)_2$ reduziert wird. Flußsaure oder fluoridhaltige Schmelzen können vorteilhaft mit $SnF_2$ versetzt werden, das nach einem Hydrolyseprozeß ebenfalls $Sn(OH)_2$ bildet und als Sensibilisator zur $Pd^{2+}$- oder $Ag^+$-Reduktion geeignet ist. Andererseits können Silberkeime auf entsprechendem Wege durch Reduktion von zugesetztem AgF z.B. mit Formaldehyd unmittelbar auf der Substratoberfläche erzeugt werden.

## Beispiel 1

Zur gleichzeitigen Vorbehandlung durch Oberflächenreinigung und Mikroaufrauhung sowie Beschichtung mit einem Haftvermittler wird eine hochreine $Al_2O_3$-Keramik (99,6 % $Al_2O_3$) in eine Natriumhydoxid-Schmelze getaucht, die 0,01 bis 10 g/l, vorzugsweise 0,5 g/l Natriumsilicat enthält, das als stöchiometrische Menge hochdisperser Kieselsäure (z.B. als Aerosil 200 der Fa. Degussa, Frankfurt) zugegeben wurde. Die Temperatur der Schmelze beträgt 350 °C. Die Dauer der Behandlung beträgt je nach gewünschtem Aufrauhungsgrad 1 bis 10 min, vorzugsweise 6 min. Anschließend wird das Keramikteil in Wasser gespült, mit $SnCl_2/PdCl_2$ inbekannter Weise aktiviert, auf eine Schichtdicke von 0,5 $\mu$m chemisch stromlos verkupfert, 10 min bei 450 °C in Stickstoffatmosphäre erhitzt und anschließend chemisch stromlos oder galvanisch weiterverkupfert. Die Haftfestigkeit einer 10-15 $\mu$m dicken Kupferschicht beträgt im senkrechten Abzugstest über 25 N/mm² und übersteigt damit die Bruchfestigkeit der Keramik.

## Beispiel 2

Verfahren gemäß Beispiel 1 mit dem Unterschied, daß der Natriumhydroxid-Schmelze anstelle von Kieselsäure 0,01 bis 10 g/l, vorzugsweise 0,3 g/l, frisch gefälltes Zinn(II)-hydroxid unter Stickstoffatmosphäre zugesetzt werden. Die Fällung wurde unmittelbar vorher durch Umsetzung von $SnCl_2$ in schwach salzsaurer Lösung mit NaOH-Lösung unter Stickstoffatmosphäre durchgeführt. Durch ein Rührwerk wird das Zinn(II)-hydroxid in der Schmelze fein verteilt bis es sich vollständig gelöst hat. Die $Al_2O_3$-Keramikteile werden in der Schmelze 1 bis 19 min, vorzugsweise 8 min, bei 450 °C behandelt, anschließend kurz in Wasser gespült, zur Aktivierung in eine schwach salzsaure $PdCl_2$-Lösung mit 0,5 g/l $PdCl_2$ getaucht und anschließend stromlos-chemisch verkupfert. Als thermische Nachbehandlung genügt infolge der stärkeren Oberflächenaufrauhung der Keramik eine Behandlung bei 150 °C für 15 min, um der nachfolgend aufgebrachten Kupferauflage eine ausreichend hohe Haftung zu verleihen.

## Beispiel 3

Verfahren gemäß Beispiel 2 mit dem Unterschied, daß anstelle von Zinn(II)-hydroxid Ag-aktiviertes Kupfer(II)-hydroxid in einer Konzentration von 0,01 bis 1o g/l, vorzugsweise 0,8 g/l, in der Schmelze eingesetzt wird. Dieses wurde vorher durch Fällung aus einer Kupfer(II)-nitratlösung mit verdünnter Natronlauge frisch hergestellt, wobei der Kupfer(II)-nitratlösung etwas Silbernitrat (im Gewichtsverhältnis Cu : Ag wie 100 : 1) zugefügt worden war. Nach dem Eintauchen der Keramikteile in die Schmelze werden diese in einer Lösung von 2 g/l $SnCl_2$, 10 g/l 35 %igem Formaldehyd und Natronlauge bis pH = 10 etwa 1 min lang vorgespült und anschließend mit Wasser klargespült. Die darauffolgende Verkupferung erfolgt wie in Beispiel 2.

Beispiel 4

Verfahren gemäß Beispiel 1 mit dem Unterschied, daß zusätzlich zur Kieselsäure in der NaOH-Schmelze ein Palladiumkolloid (Palladiummohr) in einer Konzentration von 1 g/l feinst verteilt wird. Der Pd-Eintrag in die Schmelze erfolgt dabei zweckmäßigerweise in der Form, daß das Palladiumkolloid zunächst in einem kleinen separaten Goldtiegel mit geschmolzenem Natriumhydroxid vermischt und dann erst dem Hauptteil der Schmelze unter Rühren zugesetzt wird. Nach dem Eintauchen der Keramikteile in die Schmelze und kurzem Zwischenspülen in Wasser können diese direkt chemisch verkupfert und anschließend thermisch nachbehandelt werden.

Beispiel 5

Bariumtitanat-Keramiksubstrate werden in einer Schmelze aus Ammoniumhydrogensulfat vorbehandelt, der 10 Gew.-% Zinn(II)-acetat zugesetzt wurden. Die Einwirkdauer beträgt bei einer Temperatur von 200 °C etwa 10 min. Nach Spülen in Wasser erfolgt die Belegung der Substratoberfläche mit Pd-Keimen durch Tauchen in eine salzsaure Lösung von 0,5 g/l $PdCl_2 \cdot 2\ H_2O$. Anschließend werden die Teile stromlos-chemisch verkupfert und galvanisch verstärkt. Die Haftung der Kupferauflage übertrifft die Bruchfestigkeit der Keramik.

**Patentansprüche**

1. Verfahren zur Metallisierung von Keramik, insbesondere zu deren naßchemischen Verkupferung, bei dem in einem einzigen Vorbehandlungsschnitt gleichzeitig:
   a) die Reinigung und die Aufrauhung der Keramikoberfläche durchgeführt wird, und
   b) eine chemische Aktivierung der Keramikoberfläche erfolgt und deren Belegung mit einem Haftvermittler und/oder Sensibilisator und/oder Aktivator und/oder Katalysator oder deren Vorstufen für eine nachfolgende, chemische Metallisierung, wobei die Oberfläche der Keramik in einer die Oberfläche anätzenden Schmelze, welche Substanzen, die durch Belegung der Keramikoberfläche als Haftvermittler und/oder Sensibilisator und/oder Aktivator und/oder Katalysator oder deren Vorstufen wirken, enthält und welche eine gegenüber der Raumtemperatur erhöhte Temperatur besitzt, aufgeschlossen wird und bei dem nach der Behandlung mit der Schmelze die Oberfläche gespült wird und anschließend die Metallisierung durchgeführt wird.

2. Verfahren nach Anspruch 1, dadurch gekennzeichnet, daß die Schmelze eine Temperatur in einem Temperaturbereich von 100 bis 1000 °C besitzt.

3. Verfahren nach Anspruch 1 oder 2, dadurch gekennzeichnet, daß bei einer alkalisch angreifbaren Keramik eine alkalische Schmelze, die mindestens ein Alkalihydroxid enthält und deren Temperatur in einem Temperaturbereich von 150 bis 600 °C liegt, erwendet wird.

4. Verfahren nach einem der vorhergehenden Ansprüche, dadurch gekennzeichnet daß bei einer durch Säure angreifbaren Keramik eine saure Schmelze, die Ammoniumhydrogensulfat enthält und eine Temperatur in einem Temperaturbereich von 100 bis 1200 °C besitzt, verwendet wird.

5. Verfahren nach einem der vorhergehenden Ansprüche, dadurch gekennzeichnet, daß das Vorbehandlungsmedium ein Silicat, Molybdat, Wolframat, Vanadat, Titanat, Manganat, Ferrat, Cuprat, Stannat oder ein Gemisch davon enthält.

6. Verfahren nach einem der vorhergehenden Ansprüche, dadurch gekennzeichnet, daß das Vorbehandlungsmedium einen Sensibilisator oder dessen Vorstufe enthält.

7. Verfahren nach einem der vorhergehenden Ansprüche, dadurch gekennzeichnet, daß als Sensibilisator eine Zinn(II)-Verbindung gewählt wird.

8. Verfahren nach einem der vorhergehenden Ansprüche, dadurch gekennzeichnet, daß das Vorbehandlungsmedium einen Aktivator bzw. Katalysator oder dessen Vorstufe, für die chemische Metallisierung enthält.

9. Verfahren nach einem der vorhergehenden Ansprüche, dadurch gekennzeichnet, daß als Aktivator bzw. Katalysator oder dessen Vorstufe, eine Verbindung der Elemente Ni, Cu, Ag, Au, Pd, Pt oder eines dieser Elemente selbst in feiner, kolloider Verteilung verwendet wird.

10. Verfahren nach einem der vorhergehenden Ansprüche. dadurch gekennzeichnet, daß als Haftvermittler Kupferoxid oder Kieselsäure oder ein Alkalisilicat verwendet wird.

11. Verfahren nach einem der vorhergehenden Ansprüche, dadurch gekennzeichnet, daß $Cu_2O$ als Kupferoxid verwendet wird.

## Claims

1. Method for the metallising of ceramics, in particular for their wet chemical copper plating, in which method in a single preliminary treatment step and at the same time:
   a) the cleaning and the roughening of the ceramic surface is performed and
   b) a chemical activiation of the ceramic surface takes place and its coating by an adhesive agent and/or sensitiser and/or activator and/or catalyst or their preliminary stages for a subsequent chemical metallising, wherein the ceramic surface is decomposed in a bath which starts to etch the surface and contains substances, which through coating of the ceramic surface act as adhesive agent and/or sensitiser and/or activator and/or catalyst or their preliminary stages, and which has an elevated temperature by comparison with room temperature, is decomposed and in which the surface is rinsed after the treatment with the bath and the metallising is performed subsequently.

2. Method according to claim 1, characterised thereby, that the bath has a temperature in a temperature range of 100 to 1000 °C.

3. Method according to claim 1 or 2, characterised thereby, that an alkaline bath, which contains at least one alkali hydroxide and the temperature of which lies in a temperature range of 150 to 600 °C, is used in the case of ceramics attackable alkaline.

4. Method according to one of the preceding claims, characterised thereby, that an acid bath, which contains ammonium hydrogen sulphate and has a temperature in a temperature range of 100 to 1200 °C, is used in the case of ceramics attackable by acid.

5. Method according to one of the preceding claims, characterised thereby, that the preliminary treatment medium contains a silicate, molybdate, tungstate, vanadate, titanate, manganate, ferrate, cuprate, stannate or a mixture thereof.

6. Method according to one of the preceding claims, characterised thereby, that the preliminary treatment medium contains a sensitiser or its precursor.

7. Method according to one of the preceding claims, characterised thereby, that a tin (II) compound is chosen as sensitiser.

8. Method according to one of the preceding claims, characterised thereby, that the preliminary treatment medium contains an activator or catalyst or its precursor for the chemical metallising.

9. Method according to one of the preceding claims, characterised thereby, that a compound of the elements Ni, Cu, Ag, Au, Pd, Pt or one of these elements itself is used in fine colloidal distribution is used as activator or catalyst or its precursor.

10. Method according to one of the preceding claims, characterised thereby, that copper oxide or silicic acid or an alkali silicate is used as adhesive agent.

11. Method according to one of the preceding claims, characterised thereby, that $Cu_2O$ is used as copper oxide.

## Revendications

1. Procédé de métallisation de céramique, notamment de cuivrage chimique par voie humide, dans lequel, simultanément, au cours d'une seule étape de prétraitement :
   a) la surface de la céramique est nettoyée et rendue rugueuse, et
   b) la surface de la céramique est activée chimiquement et garnie d'un adhésif et/ou d'un sensibilisateur et/ou d'un activateur et/ou d'un catalyseur ou de leurs précurseurs en vue d'une métallisation chimique subséquente, la surface de la céramique étant désagrégée dans une masse fondue décapant la surface, qui contient des substances qui, en garnissant la surface de la céramique, font fonction d'adhésif et/ou de sensibilisateur et/ou d'activateur et/ou de catalyseur ou de leurs précurseurs et possède une température supérieure à la température ambiante, et dans lequel la surface est rincée après le traitement par la masse fondue, puis la métallisation opérée.

2. Procédé selon la revendication 1, caractérisé en ce que la masse fondue possède une température comprise dans une plage de 100 à 1 000 °C.

3. Procédé selon la revendication 1 ou 2, caractérisé en ce qu'on utilise pour une céramique

sensible à une attaque basique une masse fondue alcaline contenant au moins un hydroxyde alcalin et dont la température est comprise dans une plage de 150 à 600° C.

**4.** Procédé selon l'une des revendications précédentes, caractérisé en ce qu'on utilise pour une céramique sensible à une attaque acide une masse fondue acide contenant de l'hydrogénosulfate d'ammonium et possédant une température comprise dans une plage de 100 à 1 200° C.

**5.** Procédé selon l'une des revendications précédentes, caractérisé en ce que l'agent de prétraitement contient un silicate, un molybdate, un tungstate, un vanadate, un titanate, un manganate, un ferrate, un cuprate, un stannate ou un mélange de ces substances.

**6.** Procédé selon l'une des revendications précédentes, caractérisé en ce que l'agent de prétraitement contient un sensibilisateur ou son précurseur.

**7.** Procédé selon l'une des revendications précédentes, caractérisé en ce qu'on choisit un composé d'étain(II) comme sensibilisateur.

**8.** Procédé selon l'une des revendications précédentes, caractérisé en ce que l'agent de prétraitement contient un activateur ou catalyseur ou son précurseur en vue de la métallisation chimique.

**9.** Procédé selon l'une des revendications précédentes, caractérisé en ce qu'on utilise comme activateur ou catalyseur ou son précurseur un composé des éléments Ni, Cu, Ag, Au, Pd, Pt ou un de ces éléments mêmes en dispersion colloïdale fine.

**10.** Procédé selon l'une des revendications précédentes, caractérisé en ce qu'on utilise comme adhésif de l'oxyde de cuivre ou de l'acide silicique ou un silicate alcalin.

**11.** Procédé selon l'une des revendications précédentes, caractérisé en ce qu'on utilise $Cu_2O$ comme oxyde de cuivre.